# EUROPEAN PATENT APPLICATION

(11) **EP 2 685 359 A2**
(43) Date of publication of application: **15.01.2014**
(21) Application number: 13155485.9
(22) Date of filing: 15.02.2013
(51) Int. Cl.: G06F 3/041, G06F 3/044, G06F 3/045

(54) **Touch panel and fabrication method thereof**

(30) Priority: 13.07.2012 CN 201210245042
(71) Applicant: Winsky Technology Limited, Hong Kong (CN)
(72) Inventor: Chan, Winston, Hong Kong (CN)
(74) Representative: EP&C

(57) **Abstract**

The present invention relates to touch panel and a fabrication method thereof. The method for forming touch panel disclosed in the present invention includes: forming a first pattern on a surface of a first substrate having a conductive material; forming a second pattern on a surface of a second substrate; aligning and laminating the first substrate having the first pattern and the second substrate; and cutting the laminated first substrate and second substrate into a plurality of touch panels. The present invention may resolve problems such as the high probability of substrate cracking and the high complexity of alignment of existing method for fabricating touch panel. A simple fabrication procedure may be used to perform alignment, lamination and cutting, and the yield may be further improved.

## Description

### BACKGROUND OF THE INVENTION

### 1. Field of the Invention

The present invention relates to a display panel and more particularly to a touch panel.

### 2. Description of the Related Art

The existing fabrication procedure of touch panel is as follows:
1. print a plurality of decorative frames, brand identities and/or control button patterns on a large piece of glass substrate, and then cut the large piece of glass substrate into a plurality of pieces of cover lens of the touch panel;
2. form a plurality of groups of sensing circuits on another large piece of glass substrate, and then cut the glass substrate printed with the plurality of groups of sensing circuits into a plurality of pieces of sensor glass of the touch panel;
3. aligning and laminating the cover lens and the sensor glass; and
4. align and laminate the cover lens and the sensor glass with a liquid crystal display film of the touch panel.

In the existing fabrication procedure of a touch panel, a single substrate needs to be cut, and aligned and laminated many times. Each time the substrate is cut, cracking may occur; after cutting a large piece of glass substrate, small pieces of cover lens and sensor glass are separately formed by cutting, and aligning and laminating, so the complexity of alignment and lamination increases.

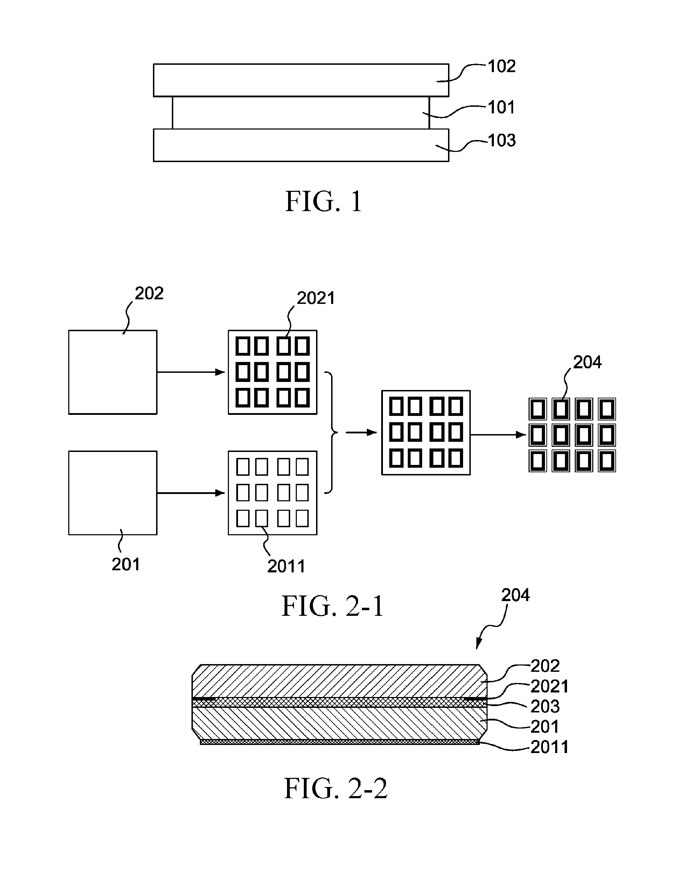

In addition, as shown in FIG. 1, after aligning and laminating sensor glass 101, cover lens 102 and liquid crystal display film 103 of a touch panel fabricated in accordance with existing method, one would notice that the size of the components is not the same so the edges are not even. Therefore, before performing subsequent encapsulation procedure, filling materials are needed to trim the edges of the laminated sensor glass 101, cover lens 102 and liquid crystal display film 103 . Also, because the sensor glass 101, the cover lens 102 and the liquid crystal display film 103 are not trimmed after alignment and lamination, the touch panel cannot be used in a device of a one glass solution (OGS).

Therefore, a method for fabricating of touch panel that simplifies the fabrication procedure, reduces the occurrence of substrate cracking, reduces the complexity of alignment, and further improves yield, is urgently needed.

### SUMMARY OF THE INVENTION

In order to simplify the fabrication process of touch panel and to eliminate danger associating with generating debris during the fabrication process of touch panel, the present invention, by simplifying the cutting procedure, solves the problem of complicated fabrication process of touch panel and the problem of debris generation , thereby effectively improves the yield, and further reduces fabrication cost.

An embodiment of the present invention discloses a method for fabricating touch panel, which includes: forming a first pattern on a surface of a first substrate having a conductive material; forming a second pattern on a surface of a second substrate; aligning and laminating the first substrate having the first pattern and the second substrate; and cutting the laminated first substrate and second substrate into a plurality of touch panels.

Another embodiment of the present invention discloses a method for fabricating touch panel, which includes: forming a first pattern on a first side of a first substrate having a conductive material; forming a second pattern on a second side opposite to the first side; laminating the first substrate having the first pattern and second pattern with a second substrate; and cutting the laminated first substrate and second substrate into a plurality of touch panels.

Another embodiment of the present invention discloses a touch panel, which includes: a first substrate, on which a conductive first pattern is printed on a surface of the first substrate; an adhesion layer, located on the first substrate; and a second substrate, located on the adhesion layer, on which a second pattern is printed on a surface of the second substrate, in which the first substrate has the same size as that of the second substrate, and edges of the first substrate and the second substrate are cut together.

Another embodiment of the present invention discloses a touch panel, which includes: a first substrate, on which a first pattern of a conductive material is printed on a first side of a surface of the first substrate and a second pattern is printed on a second side opposite to the first side; an adhesion layer, located on the second side of the first substrate; and a second substrate, located on the adhesion layer, in which the first substrate has the same size as that of the second substrate, and edges of the first substrate and the second substrate are cut together.

### BRIEF DESCRIPTION OF THE DRAWINGS

The invention is described according to the appended drawings where:

FIG. 1 shows a touch panel fabricated according to an existing method;

FIG. 2-1 shows a method for forming touch panel according to the present invention;

FIG. 2-2 shows a touch panel formed according to the method set out in FIG. 2-1;

FIG. 3-1 shows another method for forming a touch panel according to the present invention; and

FIG. 3-2 shows a touch panel formed according to the method set out in FIG. 3-1.

### PREFERRED EMBODIMENT OF THE PRESENT INVENTION

FIG. 2-1 shows a method for forming a touch panel disclosed in the present invention. First, a first pattern 2011 is formed on a surface of a first substrate 201 having a conductive material, and a second pattern 2021 is formed on a surface of a second substrate 202; then the first substrate 201 and the second substrate 202 are aligned and laminated, such as lamination by using an adhesion layer 203 (such as a scotch tape or an adhesive), and after alignment and lamination, the laminated first substrate 201 and second substrate 202 are cut into a plurality of touch panels 204. FIG. 2-2 shows a touch panel 204 formed according to the foregoing method.

According to the method of the present invention, after the first substrate 201 and the second substrate 202 are laminated, the first substrate 201 and the second substrate 202 are cut. Because of the increase of intensity, the probability of creating debris when a single substrate is cut can be reduced.

In addition, because of the touch panel of the present invention, the first substrate 201 has the same size as that of the second substrate 202, and edges of the first substrate and the second substrate are cut to have the same size without difference, the touch panel can also be used in an existing OGS device at the subsequent process, and the probability of cracking at the subsequent process is reduced.

In the present invention, the first substrate 201 is laminated to the second substrate 202 through the adhesion layer 203 and shock absorption effect may be increased, so that the probability of debris occurrence is reduced in the subsequent cutting, the edge of the cut is more even, and the processed appearance of a substrate is further improved. The material of the adhesion layer 203 can be a resin.

In an exemplary embodiment, the first substrate 201 and the second substrate 202 are transparent substrates, each of which is at least one of the following: glass, polymethyl methacrylate (PMMA), polycarbonate (PC) and polyethylene terephthalate (PET).

In an exemplary embodiment, the conductive material on the first substrate 201 is transparent, which may be indium-tin-oxide (ITO), poly (3, 4-ethylenedioxythiophene) (PEDOT) and/or a carbon nanotube.

In an exemplary embodiment, the first pattern 2011 on the first substrate 201 is a sensing circuit, which is used to sense contact and movement of a finger of a user or a touch pen. In another exemplary embodiment, the sensing circuit may be formed by performing laser scribing on the conductive material, and may also be formed on the first substrate 201 in manners such as inkjet printing and screen printing. In another exemplary embodiment, the first pattern 2011 on the first substrate 201 may be a driving circuit, an electrode and/or a conductive frame.

In an exemplary embodiment, the second pattern 2021 on the second substrate 202 is a frame, such as a decorative frame, a brand identity and/or a control button pattern of the touch panel.

In another exemplary embodiment, the liquid crystal display glass is pre-formed and the first substrate 201 and the second substrate 202 are laminated but are not cut , then they are aligned and laminated and are cut to form a plurality of touch panels. The cutting procedure may further be reduced, the probability of debris occurrence is reduced, and the yield of the touch panel is improved.

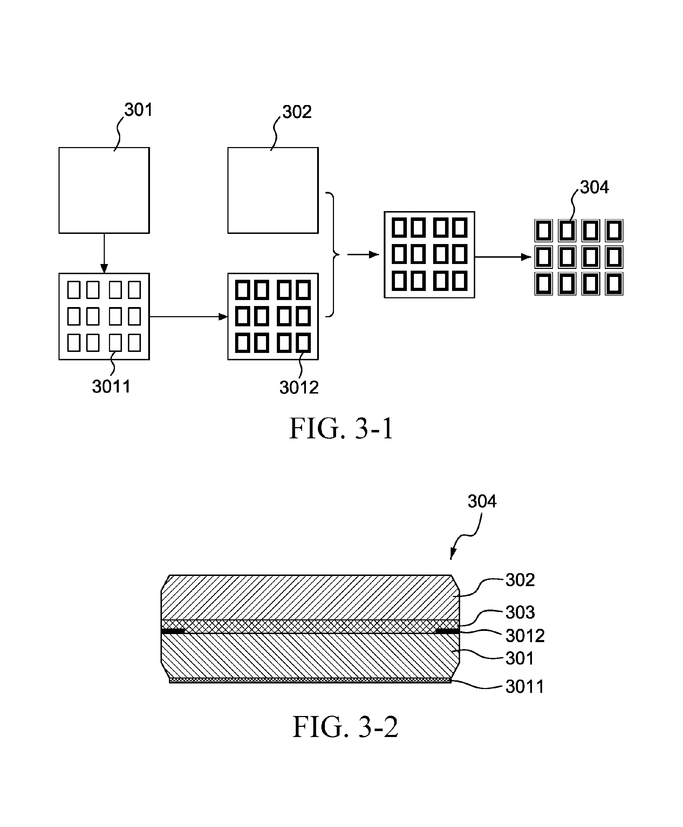

FIG. 3-1 shows another method for forming a touch panel disclosed by the present invention, including: forming a first pattern 3011 on a first side of a first substrate 301 having a conductive material, forming a second pattern 3012 on a second side opposite to the first side, laminating the first substrate 301 having the first pattern and second pattern and a second substrate 302 through an adhesion layer 303, and cutting the laminated first substrate 301 and second substrate 302 into a plurality of touch panels 304. FIG. 3-2 shows a touch panel 304 formed according to the foregoing method.

In an exemplary embodiment, the first pattern 3011 formed on the first substrate 301 is a sensing circuit, a driving circuit, an electrode and/or a conductive frame, while the second pattern 3012 opposite to the first pattern 3011 is a frame, such as a decorative frame, a brand identity and/or a control button pattern of the touch panel.

In an exemplary embodiment, the conductive material on the first substrate is transparent, which may be ITO, PEDOT and/or a carbon nanotube. The first pattern 3011 may be formed by performing laser scribing on the conductive material, and may also be formed in manners such as inkjet printing and screen printing.

In an exemplary embodiment, the first substrate 301 and the second substrate 302 are transparent substrates, each of which is at least one of the following: glass, PMMA, PC and PET.

In another exemplary embodiment, the liquid crystal display glass is pre-formed and the first substrate 301 and the second substrate 302 are laminated but are not cut, then they are aligned and laminated, and are cut to form a plurality of touch panels.

Though the technical contents and features of the present invention have been described above, modifications and improvements can still be made by persons skilled in the art without departing from the contents taught and disclosed by the present invention. Therefore, the scope of the present invention is not limited to the disclosed embodiments, and includes other modifications and improvements made without departing from the spirit of the present invention. The scope of the present invention is defined by the scope of the appended claims.

## Claims

1. A method for fabricating a touch panel, comprising:
forming a first pattern on a surface of a first substrate having a conductive material;
forming a second pattern on a surface of a second substrate;
aligning and laminating the first substrate having the first pattern and the second substrate; and
cutting the laminated first substrate and second substrate into a plurality of touch panels.

2. The method according to Claim 1, wherein the material of the first substrate and the material of the second substrate are both at least one of the following: glass, polymethyl methacrylate (PMMA), polycarbonate (PC) and polyethylene terephthalate (PET).

3. The method according to Claim 1, wherein the conductive material on the first substrate comprises at least one of the following: indium-tin-oxide (ITO), poly (3, 4-ethylenedioxythiophene) (PEDOT) and a carbon nanotube.

4. The method according to Claim 1, wherein the first pattern is a sensing circuit, and the second pattern comprises a frame.

5. The method according to Claim 4, wherein the sensing circuit is formed through laser scribing.

6. The method according to Claim 1, wherein before the plurality of touch panels is formed through cutting, the method further comprises: aligning and laminating a liquid crystal display glass, the first substrate having the first pattern and the second substrate together.

7. A method for fabricating a touch panel, comprising:
forming a first pattern on a first side of a first substrate having a conductive material;
forming a second pattern on a second side opposite to the first side;
laminating the first substrate having the first pattern and the second pattern and a second substrate; and
cutting the laminated first substrate and second substrate into a plurality of touch panels.

8. The method according to Claim 7, wherein the first pattern is a sensing circuit, and the second pattern comprises a frame.

9. The method according to Claim 7, wherein the material of the first substrate and the material of the second substrate are both at least one of the following: glass, polymethyl methacrylate (PMMA), polycarbonate (PC) and polyethylene terephthalate (PET).

10. The method according to Claim 7, wherein the conductive material on the first substrate comprises at least one of the following: indium-tin-oxide (ITO), poly (3, 4-ethylenedioxythiophene) (PEDOT) and a carbon nanotube.

11. The method according to Claim 8, wherein the sensing circuit is formed through laser scribing.

12. The method according to Claim 7, wherein before the plurality of touch panels is formed through cutting, the method further comprises: aligning and laminating a liquid crystal display glass, the first substrate having the first pattern and the second pattern, and the second substrate together.

13. A touch panel, comprising:
a first substrate, wherein a conductive first pattern is formed on a surface of the first substrate;
an adhesion layer, located on the first substrate; and
a second substrate, located on the adhesion layer, wherein a second pattern is formed on a surface of the second substrate, and the first substrate has the same size as that of the second substrate, and edges of the first substrate and the second substrate are evenly cut.

14. A touch panel, comprising:
a first substrate, wherein a first pattern of a conductive material is formed on a surface of a first side of the first substrate, and a second pattern is formed on a second side opposite to the first side;
an adhesion layer, located on the second side of the first substrate; and
a second substrate, located on the adhesion layer, wherein the first substrate has the same size as that of the second substrate, and edges of the first substrate and the second substrate are evenly cut.
